# FASCICULE DE BREVET EUROPEEN

(11) **EP 1 863 179 B1**
(45) Date de publication et mention de la délivrance du brevet: **30.12.2009**
(21) Numéro de dépôt: 07109145.8
(22) Date de dépôt: 29.05.2007
(51) Int. Cl.: H03K 3/356, H03K 19/0185

(54) **Circuit décaleur de niveau**
Niveauverschiebungsschaltkreis
Level-converter circuit

(30) Priorité: 31.05.2006 FR 0651964
(43) Date de publication de la demande: 05.12.2007
(73) Titulaire: ST MICROELECTRONICS S.A., 92120 Montrouge (FR)
(72) Inventeur: RICARD, Nicolas, 38500, COUBLEVIE (FR); MORO, Jean-Luc, 38000, GRENOBLE (FR)
(74) Mandataire: de Beaumont, Michel

(56) Documents cités:
- WO-A-2006/033638
- JP-A- 4 269 011
- JP-A- 5 284 005
- US-A1- 2003 169 225
- US-A1- 2004 263 220

## Description

### Domaine de l'invention

La présente invention concerne de façon générale les circuits décaleurs de niveau qui ont pour objet de convertir un signal d'amplitude relativement faible en un signal d'amplitude plus élevée. De tels circuits sont généralement désignés par leur appellation anglo-saxonne "Level Shifter" et se retrouvent dans des circuits d'entrée/sortie de dispositifs électroniques pour servir d'interface entre des signaux ayant des niveaux différents.

La présente invention s'applique plus particulièrement à des circuits décaleurs de niveau destinés à traiter des signaux numériques, par exemple, entre un coeur d'un circuit électronique et des périphériques de ce coeur, ou entre deux circuits. Un exemple d'application concerne la commande d'une mémoire de type DDR (Double Data Rate).

### Exposé de l'art antérieur

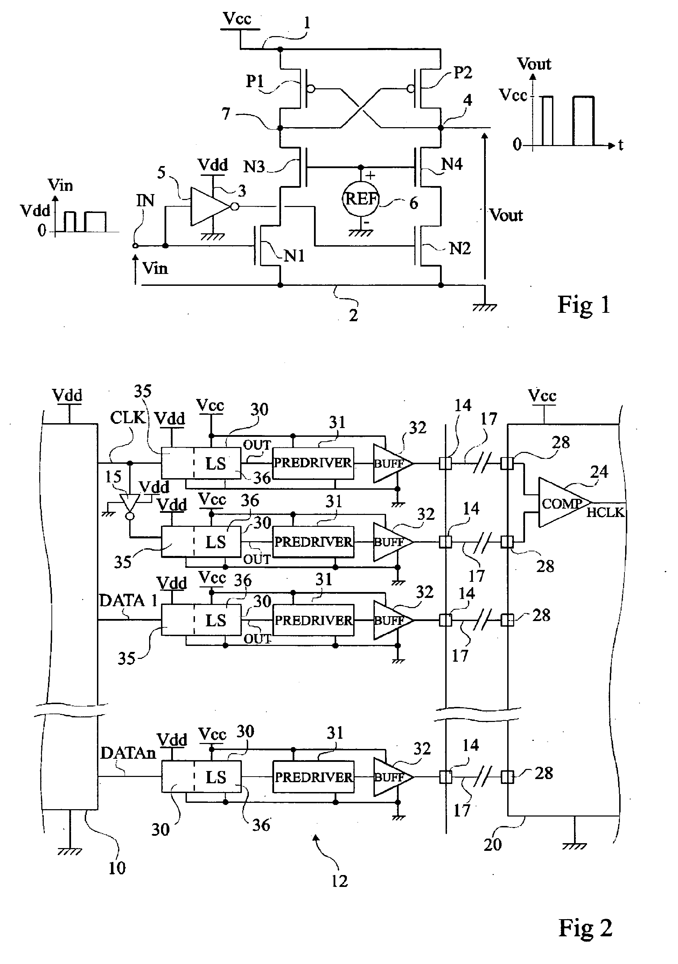

La figure 1 représente un premier exemple classique de dispositif élévateur de tension utilisé dans des circuits intégrés, par exemple, pour convertir des signaux numériques venant de blocs numériques traitant une information sous une tension Vdd relativement faible à destination de blocs dits analogiques traitant l'information sous une tension Vcc d'amplitude relativement plus élevée que la tension Vdd.

Dans la description qui suit, et sauf précision contraire, les chutes de tension à l'état passant dans les interrupteurs seront négligées, sachant que les niveaux Vcc, Vdd et la masse ne sont en pratique atteints qu'aux chutes de tension près dans les résistances série des interrupteurs à l'état passant.

Le dispositif de la figure 1 comporte deux branches parallèles entre deux bornes 1 et 2 d'application d'une tension Vcc d'alimentation relativement haute correspondant aux états souhaités pour un signal de sortie Vout. Chaque branche comporte trois transistors en série, respectivement un transistor P1 ou P2 à canal P et deux transistors N1, N3 ou N2, N4 à canal N. Les sources des transistors P1 et P2 sont reliées à la borne 1 tandis que leurs drains respectifs sont reliés aux drains respectifs des transistors N3 et N4 ainsi qu'à la grille du transistor P1 ou P2 de l'autre branche. Les sources des transistors N3 et N4 sont reliées aux drains respectifs des transistors N1 et N2 dont les sources sont connectées à la masse 2. Un signal d'entrée numérique Vin évoluant entre deux états 0 et 1 (l'état 1 étant représenté par la tension Vdd inférieure à ladite tension Vcc) est appliqué sur une borne IN reliée aux grilles respectives des transistors N1 et N2 en étant inversé (inverseur 5) pour l'une des deux branches (par exemple, pour la connexion au transistor N2). Le drain du transistor P2 définit une borne 4 de sortie fournissant le signal Vout. L'inverseur 5 est un inverseur alimenté par la tension Vdd. Une tension de référence fournie par une source de polarisation 6 (REF) est appliquée aux grilles communes des transistors N3 et N4 afin qu'ils soient rendus respectivement conducteur ou bloqué en fonction de la conduction ou du blocage du transistor N1 ou N2 auquel ils sont associés.

La structure de la figure 1 correspond à une cellule de verrouillage, par les transistors P1 et P2, du niveau présent en entrée IN sur la borne de sortie 4. Une sortie inverse peut être prise sur le drain 7 du transistor P1.

Lorsqu'un signal à l'état 0 (masse) est présent en entrée IN du dispositif, le transistor N1 est bloqué tandis que le transistor N2 est passant grâce à l'inversion opérée par l'inverseur 5. La conduction du transistor N2 se reporte sur le transistor N4 dont la grille est polarisée à un potentiel choisi pour être supérieur à la tension seuil du transistor N4 majorée de la chute de tension dans le transistor N2 à l'état passant, tandis que le transistor N3 reste bloqué. Le potentiel de la borne 4 est tiré à la masse par les transistors N4 et N2 passants. Ce potentiel bas se reportant sur la grille du transistor P1, celui-ci est rendu conducteur, ce qui verrouille le blocage du transistor P2 en portant sa grille à un niveau proche de la tension Vcc. Le potentiel obtenu en sortie 4 est donc un état bas 0 (proche de la masse) et la sortie 7 est à un niveau haut proche du niveau Vcc.

En présence d'un état haut sur l'entrée IN, les transistors N1 et N3 sont passants tandis que les transistors N2 et N4 sont bloqués. La conduction des transistors N3 et N1 provoque celle du transistor P2 en tirant sa grille à la masse ce qui élève le niveau de la borne de sortie 4 à un niveau proche du niveau Vcc. Le transistor P1 est verrouillé dans un état bloqué par ce niveau proche du niveau Vcc appliqué sur sa grille. On obtient donc bien un état haut en sortie 4 et bas en sortie 7.

Dans les applications que vise la présente invention, on distingue les transistors MOS utilisés en fonction de leurs tenues en tension respectives qui dépend, en pratique, de leur épaisseur d'oxyde. La tenue en tension des transistors varie dans le même sens que l'épaisseur d'oxyde. La vitesse de commutation du transistor varie par contre en inverse de cette épaisseur d'oxyde. Une manière de compenser cette épaisseur est d'agrandir la taille du transistor (rapport largeur sur longueur de grille - W/L).

On fera par la suite référence à la dénomination de transistors numériques pour désigner des transistors supportant une tension Vdd relativement faible (oxyde de grille relativement mince simple oxyde) et à la dénomination de transistors analogiques pour désigner des transistors supportant la tension Vcc (oxyde de grille relativement épais - double oxyde).

Dans l'exemple de la figure 1, les transistors N1 et N2 peuvent être des transistors numériques dans la mesure où la chute de tension apportée par les transistors N3 et N4 est suffisante pour limiter la tension aux bornes de ces transistors N1 et N2. Les transistors P1, P2, N3 et N4 sont par contre des transistors analogiques pour supporter la tension Vcc à leurs bornes respectives.

La figure 2 illustre, de façon schématique et sous forme de blocs, un exemple d'application de la présente invention à une interface 12 destinée à une conversion de niveaux entre un coeur 10 d'un circuit intégré et une mémoire 20 d'un autre circuit intégré. Dans une telle application, les états de signaux de données DATA1 à DATAn entre des niveaux 0 et Vdd doivent être adaptés aux niveaux de tension utilisés par la mémoire 20 entre 0 et Vcc. Un signal d'horloge différentiel CLK fourni par le coeur 10 doit également être transmis à la mémoire 20. Dans le cas d'une mémoire de type DDR, les deux fronts (montant et descendant) du signal d'horloge sont exploités par la mémoire 20, ce qui nécessite de traiter le signal CLK et son inverse (inverseur 15).

Le circuit d'entrée/sortie 12 représenté en figure 2 comporte autant de circuits décaleurs de niveau 30 (LS) qu'il y a de signaux à convertir. De plus, dans l'application aux mémoires, les sorties respectives OUT des décaleurs de niveaux 30 traversent des circuits de pré-amplification 31 (PREDRIVER), puis des amplificateurs tampon 32 (BUFF) avant que les signaux soient fournis sur des bornes de sortie 14 du circuit 12. Chaque borne 14 est reliée par un conducteur 17 d'une carte de circuit imprimé à une borne d'entrée 28 de la mémoire 20. Pour ce qui est du signal d'horloge converti HCLK, celui-ci est reconstitué au moyen d'un comparateur 24 (COMP) mettant en forme les signaux fournis sur les deux bornes 28 correspondant aux deux lignes de traitement des signaux CLK et de son inverse.

Les signaux d'entrée CLK, DATA1 et DATAn sont fournis par des circuits alimentés par la tension Vdd qui correspond donc à la tension des étages d'entrée 35 des circuits décaleurs de niveaux 30. Tous les circuits en aval des décaleurs de niveau 30, de même que les étages de sortie 36 de ces circuits, sont alimentés par la tension Vcc relativement élevée. Par exemple, la tension Vdd est de l'ordre du volt tandis que la tension Vcc est de 2,5 volts, voire 1,8 volts.

Ce qui a été exposé en relation avec un bloc numérique 10 et un bloc dit analogique 20 de deux circuits électroniques distincts reliés l'un à l'autre par des conducteurs 17 d'une carte de circuit imprimé, s'applique également à deux blocs d'un même circuit intégré relié par des pistes conductrices.

Dans les interfaces destinées aux mémoires, les circuits décaleurs de niveaux 30 classiques sont du type de ceux illustrés par la figure 1. Ces circuits permettent un fonctionnement à des fréquences jusqu'à quelques centaines de Mégahertz.

Un inconvénient du circuit décaleur de niveau de la figure 1 est que pour fonctionner à des fréquences de plusieurs centaines de mégahertz, les transistors analogiques doivent être de taille relativement importante. Cela augmente la consommation dynamique du circuit, génère des appels de courant importants et de rebonds sur les alimentations. Cela perturbe donc le signal.

Un autre inconvénient du circuit de la figure 1 est que le rapport cyclique du signal de sortie est dépendant de la température, des tensions Vcc et Vdd, des conditions de fabrication et des différences entre les transistors MOS à canal N et à canal P, ainsi qu'entre les transistors N1 et N2.

Un autre inconvénient du circuit de la figure 1 est qu'un éventuel bruit d'alimentation sur le signal numérique peut engendrer un déphasage en sortie. En d'autres termes, une variation du temps de propagation entre les bornes IN et OUT se traduit par un bruit de phase sur le signal.

Ces contraintes font qu'en pratique un décaleur de niveau tel qu'illustré en figure 1 est limité à une fréquence de 3 à 400 Mégahertz.

Une des contraintes de l'application à une mémoire telle qu'illustrée par la figure 2 est que des signaux de données (non périodiques) doivent être fournis à la mémoire de façon synchrone avec le signal d'horloge. Par conséquent, le temps de propagation dans les circuits d'entrée/sortie de l'horloge différentielle obtenue à partir du signal CLK doit être le même que dans les circuits d'entrée/sortie traitant des données. Il en découle une obligation pratique d'avoir des circuits décaleurs de niveau identiques à la fois pour les données et pour le signal d'horloge, donc deux décaleurs de niveaux pour le signal d'horloge.

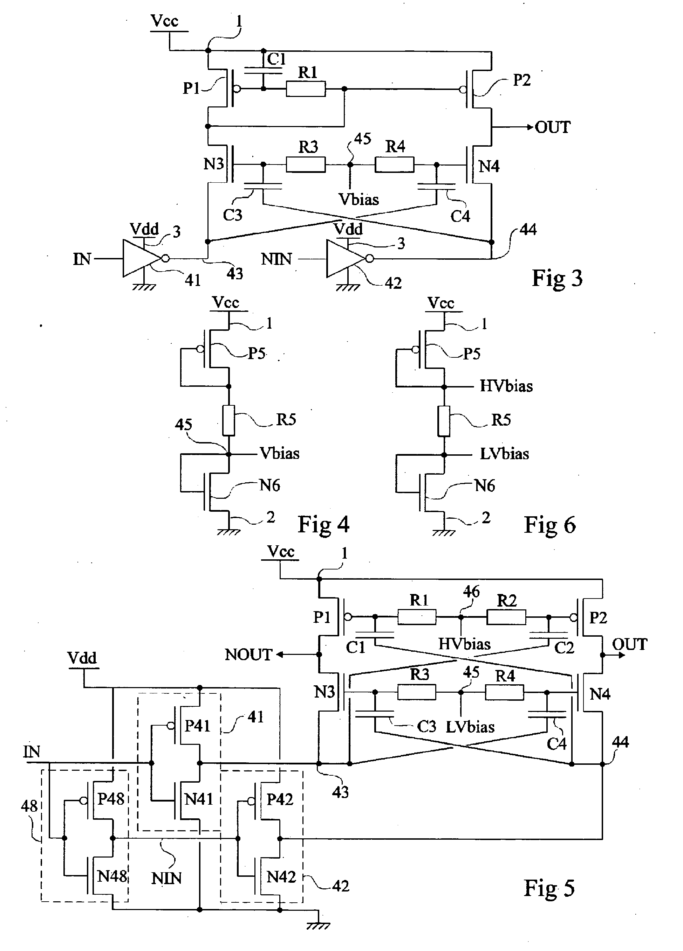

La figure 3 représente un deuxième exemple de circuit décaleur de niveau connu. Ce circuit est décrit dans la demande de brevet américain 2004/263220.

Le circuit de la figure 3 comporte deux inverseurs 41 et 42 constitués de transistors numériques (alimentés par la tension Vdd) et recevant respectivement le signal IN à reproduire sur une borne OUT de sortie et l'inverse NIN de ce signal. Les signaux IN et NIN peuvent provenir de bascules du circuit numérique si l'application requiert une synchronisation parfaite entre ces signaux. Les bornes de sortie respectives 43 et 44 des inverseurs sont chacune reliées à une borne 1 (positive) d'application de la tension Vcc par deux transistors en série respectivement N3 ou N4 à canal N, et P1 ou P2 à canal P, les transistors à canal P étant côté borne 1. Chaque sortie 43 ou 44 est par ailleurs reliée à une première électrode d'un élément capacitif C3 ou C4 dont la deuxième électrode est connectée à la grille du transistor N4 ou N3 de l'autre branche. Les grilles respectives des transistors N3 et N4 sont par ailleurs reliées, par des éléments résistifs R3 et R4, à une borne 45 d'application d'une tension de polarisation (positive dans cet exemple) Vbias. Le transistor P2 a sa grille reliée au drain du transistor P1 tandis que son propre drain constitue la borne de sortie OUT. La grille du transistor P1 est reliée par une résistance R1 à la grille du transistor P2 et par un condensateur C1 à la borne 1.

Le rôle des éléments capacitifs C3 et C4 est de transmettre directement sur les grilles des transistors N3 et N4 les fronts fournis par les inverseurs 41 et 42, ce qui permet d'accélérer la vitesse de commutation du décaleur de niveau. Les résistances R3 et R4 participent à la création de cellules résistives et capacitives avec les éléments C3 et C4, apportant une constante de temps à la décharge de la grille du transistor N3 ou N4 qui a été portée à l'état haut.

La résistance R1 et le condensateur C1 apportent un retard à la commutation du transistor P1 par rapport à celle du transistor P2, ce qui accroît la vitesse de commutation du transistor P2.

Le potentiel de polarisation Vbias, choisi pour être supérieur à la tension de seuil du transistor N4, est inférieur à la somme de cette tension seuil et de la tension d'alimentation Vdd côté numérique.

Dans le circuit de la figure 3, les transistors P1, P2, N3 et N4 sont tous des transistors analogiques mais sont rendus rapides grâce à une commande capacitive. De plus, ils sont de taille plus petite, engendrent moins de consommation, moins d'appel de courant, donc moins de bruit sur les alimentations. En outre, le temps de propagation des fronts montants et descendants (donc le rapport cyclique) devient indépendant de la tension Vdd, de la température et des conditions de fabrication.

La figure 4 représente schématiquement un exemple de réalisation d'une source de tension fournissant la tension de polarisation Vbias sur le noeud 45 du circuit de la figure 3. Cette source de tension est constituée d'une association en série d'un transistor MOS P5 à canal P, d'une résistance R5 et d'un transistor MOS N6 à canal N entre les bornes 1 et 2 d'application de la tension Vcc. Le transistor P5 est monté en diode, sa grille étant reliée à son drain relié à une première borne de la résistance R5. Le transistor N6 est lui aussi monté en diode, sa grille étant reliée à son drain relié à l'autre extrémité de la résistance R5 et définissant la borne 45 de fourniture de la tension Vbias. Les transistors P5 et N6 sont des transistors analogiques.

Un inconvénient du circuit décaleur de niveau de la figure 3 est qu'une gigue de phase apparaît en cas de signal d'entrée IN non périodique.

Cette gigue de phase provient notamment de la diode (même retardée) constituée par le transistor P1 qui entraîne que le niveau de la grille du transistor P2 garde en mémoire (accumule l'historique) des commutations passées. Il en découle que, plus le signal d'entrée reste longtemps dans un état stable, plus le niveau de cette grille augmente pour tendre vers le niveau Vcc diminué de la tension seuil du transistor P2 (typiquement de l'ordre de 0,2 V). Par conséquent, si le signal d'entrée ne commute pas de façon périodique, le temps de propagation dans le décaleur de niveau dépend du signal d'entrée. Un tel phénomène ne se produit pas pour un signal d'horloge périodique (la grille du transistor P2 se décharge avec la même périodicité qu'elle se charge), mais provoque une gigue de phase dans le cas d'un signal non périodique (typiquement, un signal de données). Cela réduit la fenêtre d'acquisition (durée pendant laquelle on est sûr d'avoir la donnée à l'état 1 ou 0) en raison d'une augmentation des incertitudes sur l'état de la donnée.

En d'autres termes, un tel circuit décaleur de niveau présente par rapport à celui de la figure 1 l'avantage d'être rapide pour le traitement d'un signal d'horloge mais ne convient pas pour un signal d'entrée pseudoaléatoire, même si les fronts de ce signal d'entrée sont synchrones avec un signal d'horloge. Or, c'est notamment le cas dans l'application de données à convertir au moyen d'un circuit d'entrée/sortie du type de celui illustré par la figure 2 et plus généralement dès que le signal à convertir n'est pas un signal d'horloge.

Le document JP05 284 005 A décrit un dispositif décaleur de niveau comportant une branche de deux transistors de types opposés connectés en série dont le point milieu définit une borne de sortie, l'un des transistors recevant un signal d'entrée sur la source et un signal dérivé du signal d'entrée sur la grille par un circuit générateur d'impulsions, l'autre recevant sur la grille le signal d'entrée inversé par un filtre passe haut. Notamment le circuit générateur d'impulsions et le circuit d'entrée comportent un nombre de composants élevé. De plus ce circuit ne prévoit pas un ajustement des potentiels de polarisation des transistors.

### Résumé de l'invention

La présente invention vise à pallier tout ou partie des inconvénients des circuits décaleurs de niveaux connus.

L'invention vise plus particulièrement un circuit décaleur de niveau susceptible de fonctionner à des fréquences élevées (typiquement, de l'ordre du Gigahertz).

L'invention vise également un circuit compatible avec un signal d'entrée périodique ou pseudoaléatoire.

L'invention vise également une solution à faible consommation.

L'invention vise également une solution peu encombrante.

Pour atteindre tout ou partie de ces objets ainsi que d'autres, la présente invention prévoit un dispositif décaleur de niveau d'un premier signal d'amplitude relativement faible fonction d'une première tension d'alimentation en un deuxième signal d'amplitude relativement élevée fonction d'une deuxième tension d'alimentation, comportant, entre une première borne d'application de la deuxième tension d'alimentation et une première borne d'entrée, une branche de deux transistors de types opposés en série dont le point milieu définit une borne de sortie, les bornes de commande respectives des transistors étant reliées à des bornes d'application de potentiels de polarisation relativement haut et bas par des premiers éléments résistifs, une deuxième borne d'entrée, recevant l'inverse du signal appliqué sur la première borne, étant reliée à chacune des bornes de commande des transistors par des premiers éléments capacitifs et la première borne d'entrée étant reliée à chacune des bornes d'application des potentiels de polarisation par des deuxièmes éléments capacitifs en série avec des deuxièmes éléments résistifs.

Selon un mode de réalisation de la présente invention, les potentiels de polarisation sont tels que le potentiel bas a tendance à rendre le transistor relié à ladite première borne d'entrée plus passant que le transistor relié à ladite première borne d'alimentation.

Selon un mode de réalisation de la présente invention, une deuxième branche de deux transistors de types opposés en série relie ladite première borne d'application de la deuxième tension d'alimentation à la deuxième borne d'entrée, les bornes de commande des transistors de la deuxième branche étant reliées aux points milieux des associations en série des deuxièmes éléments capacitifs et résistifs, le point milieu de la deuxième branche définissant une deuxième borne de sortie fournissant un signal inversé par rapport au signal fourni par la première borne de sortie.

Selon un mode de réalisation de la présente invention, les éléments capacitifs ont des valeurs de l'ordre du femto-Farad.

Selon un mode de réalisation de la présente invention, les éléments capacitifs ont tous les mêmes valeurs, les éléments résistifs ayant tous les mêmes valeurs.

Selon un mode de réalisation de la présente invention, les éléments capacitifs associés aux transistors d'un premier type sont de valeur inférieure aux éléments capacitifs associés aux transistors d'un deuxième type, les éléments résistifs correspondants suivant une variation inverse.

Selon un mode de réalisation de la présente invention, lesdites bornes d'entrée correspondent aux sorties respectives d'inverseurs recevant en entrée des signaux numériques inversés l'un par rapport à l'autre, lesdits inverseurs étant alimentés par ladite première tension d'alimentation.

Selon un mode de réalisation de la présente invention, ladite première borne d'application de la deuxième tension d'alimentation est reliée à chaque borne de sortie par un transistor additionnel du premier type, la borne de commande de chaque transistor additionnel étant reliée par un interrupteur commandable à l'autre borne de sortie.

Selon un mode de réalisation de la présente invention, les transistors du premier type sont des transistors MOS à canal P, les transistors du deuxième type étant des transistors MOS à canal N, les tensions d'alimentation étant positives par rapport à un niveau de référence commun.

La présente invention prévoit également un dispositif d'entrée/sortie recevant au moins un premier signal numérique d'amplitude relativement faible d'un circuit numérique et fournissant au moins un signal d'amplitude relativement élevée à destination d'un deuxième circuit, comportant au moins un dispositif décaleur de niveau.

Selon un mode de réalisation de la présente invention, le dispositif reçoit un signal non périodique.

Selon un mode de réalisation de la présente invention, le signal converti est un signal d'horloge différentiel.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente un premier exemple classique de circuit décaleur de niveaux ;
la figure 2 représente, de façon très schématique et sous forme de blocs, un exemple de circuits d'entrée/sortie du type auquel s'applique à titre d'exemple la présente invention ;
la figure 3 représente un deuxième exemple connu de circuit décaleur de niveau ;
la figure 4 décrite précédemment représente un exemple de circuit de génération d'une tension de polarisation du circuit de la figure 3 ;
la figure 5 représente un décaleur de niveau selon un premier mode de réalisation de la présente invention ;
la figure 6 représente un exemple de circuit de fourniture de tensions de polarisation du dispositif de la figure 5 ;
la figure 7 représente, de façon très schématique et sous forme de blocs, un exemple d'application d'un décaleur de niveau de l'invention à un circuit d'interface d'horloge différentielle ;
la figure 8 représente un deuxième mode de réalisation d'un décaleur de niveau selon la présente invention ; et
la figure 9 représente une variante du décaleur de niveau de la figure 5.

De mêmes éléments ont été désignés par de mêmes références aux différentes figures. Pour des raisons de clarté, seuls les éléments utiles à la compréhension de l'invention ont été représentés et seront décrits. En particulier, les circuits de génération des signaux numériques à convertir de même que les circuits d'exploitation de ces signaux n'ont pas été détaillés, l'invention étant compatible avec toute exploitation classique d'un décaleur de niveau.

### Description détaillée

L'invention sera décrite par la suite plus particulièrement en relation avec un exemple d'application à la commande d'une mémoire DDR. Elle s'applique toutefois plus généralement à tout circuit ayant recours à un décaleur de niveau, par exemple, les interfaces USB, les interfaces série différentielles LVDS (Low Voltage Differential Signal), etc.

La figure 5 représente un premier mode de réalisation d'un circuit décaleur de niveau selon la présente invention.

Comme précédemment, le circuit décaleur de niveau exploite des signaux IN et NIN fournis, par exemple, en entrée d'inverseurs 41 et 42 alimentés par la tension Vdd côté bloc numérique et dont les sorties respectives 43 et 44 sont chacune reliées à une borne 1 d'application de la tension Vcc côté analogique par l'intermédiaire de deux transistors N3, P1 et N4, P2 respectivement à canal N et à canal P. Toujours comme précédemment, les grilles respectives des transistors N3 et N4 sont reliées aux sorties 44 et 43 au moyen d'éléments capacitifs C3 et C4 et à une borne 45 d'application d'un premier potentiel LVbias de polarisation par des résistances R3 et R4.

Selon ce mode de réalisation de l'invention, les sorties respectives 43 et 44 des inverseurs 41 et 42 sont également reliées aux grilles respectives des transistors P2 et P1 de la branche opposée par des éléments capacitifs respectivement C2 et C1, les grilles des transistors P1 et P2 étant par ailleurs reliées à une borne 46 d'application d'un deuxième potentiel de polarisation HVbias par des résistances R1 et R2. Le drain du transistor P2 correspondant au drain du transistor N4 définit une borne OUT de sortie dite arbitrairement directe (reproduisant le signal IN ou l'inverse du signal de la borne 43) tandis que le drain du transistor P1 commun au drain du transistor N3 définit une borne de sortie dite arbitrairement inverse NOUT (reproduisant le signal NIN ou l'inverse du signal de la borne 44). Les transistors P1 et P2 sont de taille identique, de même que les transistors N3 et N4.

Le rôle du signal LVbias est de rendre passant l'un des transistors N3 et N4. Le rôle du signal HVbias, d'un niveau supérieur au signal LVbias, est de rendre passant l'un des transistors P1 et P2 en fonction du signal d'entrée.

Un avantage de la structure proposée par la figure 5 est de supprimer la gigue de phase due à un signal non périodique.

Un autre avantage est de permettre un fonctionnement à sorties différentielles, ce que ne permet pas le circuit de la figure 3 exposé précédemment.

La figure 6 représente un exemple de circuit de génération des potentiels de polarisation LVbias et HVbias. Ce circuit reprend la structure exposée précédemment en relation avec la figure 4 à savoir un transistor MOS à canal P P5 (monté en diode) en série avec une résistance R5 et avec un transistor MOS à canal N N6 (également monté en diode) entre les bornes 1 et 2. Le drain du transistor P5 fournit le potentiel relativement haut de polarisation HVbias tandis que le transistor N6 fournit le potentiel relativement bas de polarisation LVbias.

Les niveaux des signaux HVbias et LVbias sont choisis de préférence de telle sorte que le signal LVbias rend le transistor N4 ou N3 plus passant que le transistor P2 ou P1 respectif de la branche concernée. Cela garantit un niveau bas (0) sur la borne OUT en statique lorsque l'entrée IN est au niveau haut (1).

D'autres circuits de polarisation pourront être prévus, pourvu de respecter la fourniture d'un potentiel LVbias supérieur à la tension seuil des transistors N3 et N4 et, de préférence, de respecter la condition ci-dessus sur les transistors N3 et N4 par rapport aux transistors P2 et P1. Dans l'exemple de la figure 6, cela conduit à prévoir un transistor N6 ayant un rapport largeur/longueur de grille (W/L) inférieur à celui des transistors N3 et N4.

Côté polarisation haute (HVbias), les transistors P5, P1 et P2 seront de préférence choisis avec la même tension de seuil (donc avec des tailles identiques) de façon à minimiser la consommation.

Les valeurs respectives des éléments capacitifs C1, C2, C3, C4 et des résistances R1, R2 et R3 et R4 sont choisies en fonction des constantes de temps souhaitées (adaptées à la fréquence de fonctionnement) pour les cellules RC que forment ces éléments. Toutes les constantes de temps sont de préférence sensiblement identiques. De préférence, les condensateurs C1 et C2 ont des valeurs identiques de même que les condensateurs C3 et C4, les résistances R1 et R2, et les résistances R3 et R4. Toutefois, on pourra prévoir qu'elles soient obtenues avec des éléments individuels différents d'une cellule RC à l'autre. Par exemple, on pourra prévoir des condensateurs C1 et C2 de valeur supérieure aux condensateurs C3 et C4 pour le cas où les transistors MOS à canal P P1 et P2 aient des rapports largeur/longueur de grille plus grands que les transistors N3 et N4 engendrant alors des capacités de grille supérieures pour ces éléments. La compensation sur les constantes de temps obtenues est alors effectuée en diminuant les valeurs des résistances R1 et R2 par rapport aux résistances R3 et R4.

L'ordre de grandeur des éléments capacitif C1 à C4 est le femto-Farad, ce qui les rend intégrables. L'ordre de grandeur des éléments résistifs est le kilo-ohms et ils sont donc également intégrables.

En figure 5, les inverseurs 41 et 42 ont été représentés par leurs schémas respectifs de deux transistors MOS à canal P P41, respectivement P42, et à canal N N41, respectivement N42, en série entre les bornes 3 et 2 d'application de la tension Vdd et dont les grilles reçoivent respectivement les signaux IN (transistors P41 et N41) et NIN (transistors P42 et N42).

Par ailleurs, un inverseur supplémentaire optionnel 48, constitué de deux transistors MOS P48 à canal P et N48 à canal N en série entre les bornes 3 et 2, a été représenté pour illustrer un exemple de génération du signal NIN pour le cas où le bloc numérique ne fournisse que le signal IN. Les grilles des transistors P48 et N48 reçoivent le signal IN et leur drain commun fournit le signal NIN.

En variante, la borne 43 est reliée à l'entrée de l'inverseur 42 et l'inverseur 41 est supprimé.

En outre, les inverseurs 41 et 42 utilisés pour les signaux d'entrée IN et NIN pourront le cas échéant correspondre à des éléments des circuits numériques. Par exemple, il pourra s'agir de circuits tampons formés de transistors numériques ou tout autre moyen de commande capable d'absorber un courant statique. Cela revient à considérer que les bornes 43 et 44 reçoivent respectivement des signaux inverses et directs référencés par rapport à la tension Vdd en guise de signaux d'entrée. Les inverseurs 41 et 42 ont été illustrés pour tenir compte de la présence d'un transistor MOS à canal N entre la borne 43 et la masse 2 et entre la borne 44 et la masse 2.

Un avantage de la solution de la figure 5 est qu'elle permet une structure rapide profitant d'une transmission capacitive des fronts du signal d'entrée sans pour autant engendrer de décalage en cas de signaux d'entrée non périodiques. En effet, la symétrie de la structure évite cet inconvénient du circuit classique.

Un autre avantage est que seule une des branches de la structure présente une consommation statique et que la consommation statique globale est donc indépendante de l'état en entrée.

Par exemple, si l'entrée IN est à l'état 1, le transistor N4 est bloqué et la borne de sortie OUT est tirée au potentiel Vcc grâce au transistor P2. Aucun courant statique ne circule dans la branche N4-P2. Dans l'autre branche, les deux transistors P1 et N3 sont passants. En conséquence, la seule consommation provient de la consommation dans la branche P1-N3 (par le transistor bas N41 de l'inverseur 41 rendu passant pour que la sortie 43 soit au niveau 0). Si le signal IN est à l'état 0, il n'y a pas de courant dans la branche N3-P1 mais une légère consommation dans la branche P2-N4 (par le transistor bas N42 de l'inverseur 42).

Quel que soit l'état du signal d'entrée, la consommation statique de la structure est donc égale au courant de polarisation fourni par le transistor P5 ou tiré par le transistor N6, majoré du courant dans l'une des deux branches.

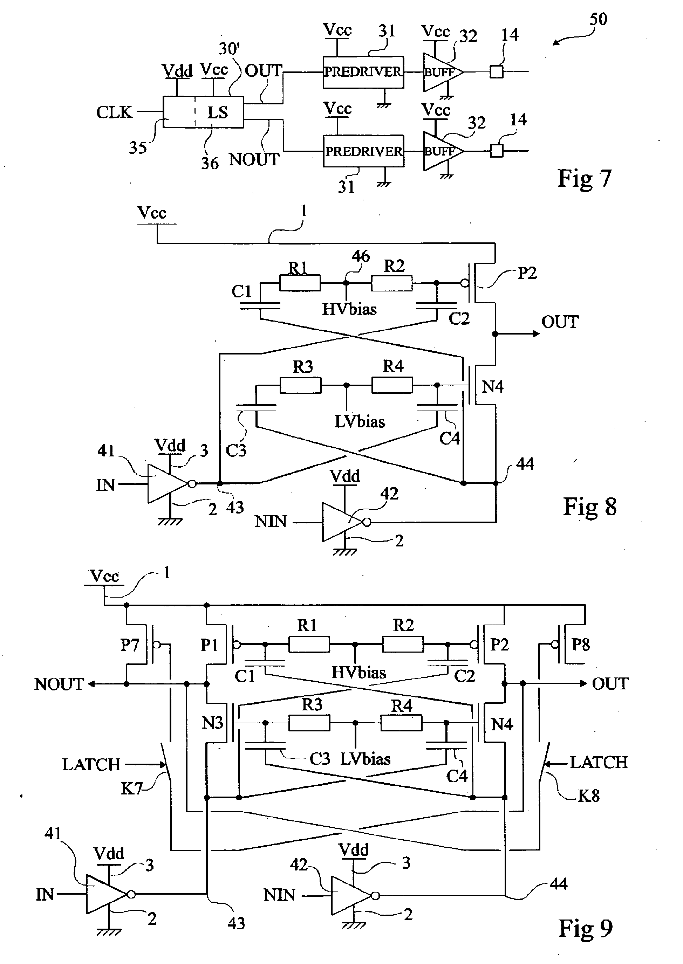

La figure 7 illustre l'utilisation d'un circuit décaleur de niveau du type de celui de la figure 5 dans une application à un étage 50 de sortie d'un signal d'horloge différentiel CLK, par exemple dans l'application illustrée par la figure 2. Par rapport au circuit de la figure 2, la structure différentielle du décaleur de niveau de la figure 5 permet de n'utiliser qu'un seul décaleur 30' dont les deux sorties OUT et NOUT sont envoyées sur les entrées des circuits de pré-amplification 31 (PREDRIVER) de chacune des branches. Comme précédemment, on retrouve généralement des amplificateurs tampon 32 (BUFF) avant les bornes de sortie analogiques 14 destinées à la mémoire non représentée.

Un autre avantage de la présente invention dans cette application est que l'on économise un circuit décaleur de niveau dans l'interface de sortie et la consommation associée.

Un avantage de l'invention est que les décaleurs de niveaux exploitant les signaux de données DATA1 à DATAn, (figure 2) peuvent être identiques au décaleur de niveaux du signal d'horloge, le dispositif de l'invention étant compatible à la fois avec des signaux périodiques et avec des signaux pseudo aléatoires (non périodiques).

En cas d'utilisation de plusieurs décaleurs de niveaux dans un même dispositif d'entrée-sortie, ceux-ci peuvent partager des mêmes signaux HVbias et LVbias.

La figure 8 représente un deuxième mode de réalisation d'un décaleur de niveau selon l'invention appliqué à une sortie non différentielle. Dans ce cas, les transistors P1 et N3 de la figure 5 peuvent être omis, le reste du circuit étant identique. On veillera toutefois à maintenir la symétrie des éléments capacitifs de façon à ne pas perturber les tensions de polarisation par des courants dynamiques provoqués par les fronts des signaux IN et NIN. Un avantage qu'il y a à supprimer les transistors P1 et N3 si la structure différentielle n'est pas nécessaire est de réduire les consommations statique et dynamique.

La figure 9 représente une variante du dispositif de la figure 5 adaptée à un choix entre le fonctionnement décrit en relation avec la figure 5 et un fonctionnement sous fréquence plus basse mais sans consommation statique. Une telle variante peut, par exemple, être utilisée dans les tests des circuits d'entrée/sortie pour lesquels on souhaite pouvoir exploiter les décaleurs de niveau sans pour autant engendrer de consommation.

En figure 9, deux transistors MOS à canal P additionnels P7 et P8 sont placés en parallèle avec les transistors P1 et P2 respectivement. Les grilles de ces transistors sont reliées à la borne de sortie OUT, NOUT de la branche opposée par l'intermédiaire d'un interrupteur K7, respectivement K8, commandé par un signal LATCH. Les transistors P7 et P9 reproduisent en quelque sorte la structure de verrouillage de la figure 1 en profitant ici de la présence des transistors N3 et N4 de la structure de la figure 5. Les interrupteurs K7 et K8 sont des interrupteurs à transistors MOS constitués par exemple, de deux transistors à canal N et P pour former une porte de transfert (pass gate).

Bien que cela n'ait pas été représenté en figure 9, le passage en mode test ou faible consommation sous commande du signal LATCH provoque non seulement la fermeture des interrupteurs K7 et K8 mais également le blocage forcé des transistors P1, P2 et la conduction forcée des transistors N3 et N4 en portant les potentiels HVbias et LVbias au niveau Vcc et Vdd respectivement. La tension source des transistors 43 et 44 reste inférieure au niveau Vdd pour ne pas endommager les transistors des inverseurs 41, 42 et 48.

Bien entendu, la présente invention est susceptible de diverses variantes et modifications qui apparaîtront à l'homme de l'art. En particulier, le choix des résistances et éléments capacitifs est à la portée de l'homme du métier en fonction des fréquences de fonctionnement choisies pour que les constantes de temps correspondent approximativement à la demi-période maximale susceptible d'être traité par le circuit décaleur de niveau.

De plus, bien que l'invention ait été exposée en relation avec un décaleur de niveau positif, elle se transpose sans difficulté en inversant les types de conductivité des transistors à un décaleur de niveau vers des tensions négatives.

En outre, bien que l'on ait fait référence à des potentiels positifs et à une masse, on comprendra aisément qu'il s'agit de potentiels relatifs les uns par rapport aux autres pourvu que les signaux d'entrée et de sortie aient un potentiel commun (généralement la masse).

Enfin, bien que l'invention ait été exposée en relation avec des transistors MOS, les transistors analogiques pourront être remplacés par d'autres commutateurs tels que des transistors IGBT.

## Revendications

1. Dispositif décaleur de niveau d'un premier signal (Vin) d'amplitude relativement faible fonction d'une première tension d'alimentation (Vdd) en un deuxième signal (Vout) d'amplitude relativement élevée fonction d'une deuxième tension d'alimentation (Vcc) comportant, entre une première borne (1) d'application de la deuxième tension d'alimentation et une première borne (44) d'entrée, une branche de deux transistors (P2, N4) de types opposés en série dont le point milieu définit une borne de sortie (OUT), les bornes de commande respectives des transistors étant reliées à des bornes (46, 45) d'application de potentiels de polarisation relativement haut (HVbias) et bas (LVbias) par des premiers éléments résistifs (R2, R4), une deuxième borne d'entrée (43), recevant l'inverse du signal appliqué sur la première borne, étant reliée à chacune des bornes de commande des transistors par des premiers éléments capacitifs (C2, C4) et la première borne d'entrée étant reliée à chacune des bornes d'application des potentiels de polarisation par des deuxièmes éléments capacitifs (C1, C3) en série avec des deuxièmes éléments résistifs (R1, R3).

2. Dispositif selon la revendication 1, dans lequel les potentiels de polarisation (HVbias, LVbias) sont tels que le potentiel bas a tendance à rendre le transistor (N4) relié à ladite première borne d'entrée plus passant que le transistor (P1) relié à ladite première borne d'alimentation (1).

3. Dispositif selon l'une quelconque des revendications 1 à 2, dans lequel une deuxième branche de deux transistors (P1, N3) de types opposés en série relie ladite première borne (1) d'application de la deuxième tension d'alimentation (Vcc) à la deuxième borne d'entrée (43), les bornes de commande des transistors de la deuxième branche étant reliées aux points milieux des associations en série des deuxièmes éléments capacitifs (C2, C4) et résistifs (R2, R4), le point milieu de la deuxième branche définissant une deuxième borne de sortie (NOUT) fournissant un signal inversé par rapport au signal fourni par la première borne de sortie.

4. Dispositif selon l'une quelconque des revendications 1 à 3, dans lequel les éléments capacitifs (C1 C2, C3, C4) ont des valeurs de l'ordre du femto-Farad.

5. Dispositif selon l'une quelconque des revendications 1 à 4, dans lequel les éléments capacitifs (C1, C2, C3, C4) ont tous les mêmes valeurs, les éléments résistifs (R1, R2, R3, R4) ayant tous les mêmes valeurs.

6. Dispositif selon l'une quelconque des revendications 1 à 4, dans lequel les éléments capacitifs (C3, C4) associés aux transistors d'un premier type (N3, N4) sont de valeur inférieure aux éléments capacitifs (C1, C2) associés aux transistors d'un deuxième type (P1, P2), les éléments résistifs correspondants (R3, R4, R1, R2) suivant une variation inverse.

7. Dispositif selon l'une quelconque des revendications 1 à 6, dans lequel lesdites bornes d'entrée (43, 44) correspondent aux sorties respectives d'inverseurs (41, 42) recevant en entrée des signaux numériques inversés l'un par rapport à l'autre, lesdits inverseurs étant alimentés par ladite première tension d'alimentation (Vdd).

8. Dispositif selon la revendication 3 et l'une quelconque des revendications 4 à 7, dans lequel ladite première borne (1) d'application de la deuxième tension d'alimentation (Vcc) est reliée à chaque borne de sortie (NOUT, OUT) par un transistor additionnel du premier type (P7, P8), la borne de commande de chaque transistor additionnel étant reliée par un interrupteur commandable (K7, K8) à l'autre borne de sortie.

9. Dispositif selon l'une quelconque des revendications 1 à 8, dans lequel les transistors du premier type sont des transistors MOS à canal P (P1, P2, P7, P8), les transistors du deuxième type étant des transistors MOS à canal N (N3, N4), les tensions d'alimentation (Vdd, Vcc) étant positives par rapport à un niveau de référencé commun (2).

10. Dispositif d'entrée/sortie recevant au moins un premier signal numérique (Vin) d'amplitude relativement faible d'un circuit numérique (10) et fournissant au moins un signal d'amplitude relativement élevée à destination d'un deuxième circuit (20), **caractérisé en ce qu'**il comporte au moins un dispositif décaleur de niveau selon l'une quelconque des revendications précédentes.

11. Dispositif selon la revendication 10, recevant un signal non périodique.

12. Dispositif selon la revendication 10, dans lequel le signal converti est un signal d'horloge différentiel.

## Claims

1. A device for shifting the level of a first signal (Vin) of relatively low amplitude which is a function of a first supply voltage (Vdd) to a second signal (Vout) of relatively high amplitude which is a function of a second supply voltage (Vcc), comprising, between a first terminal (1) of application of the second supply voltage and a first input terminal (44), a branch of two transistors (P2, N4) of opposite types in series, having their junction point defining an output terminal (OUT), the respective control terminals of the transistors being connected to terminals (46, 45) of application of relatively high (HVbias) and low (LVbias) bias voltages by first resistive elements (R2, R4), a second input terminal (43), receiving the inverse of the signal applied on the first terminal, being connected to each of the control terminals of the transistors by first capacitive elements (C2, C4) and the first input terminal being connected to each of the terminals of application of the bias voltages by second capacitive elements (C1, C3) in series with second resistive elements (R1, R3).

2. The device of claim 1, wherein the bias voltages (HVbias, LVbias) are such that the low voltage tends to make the transistor (N4) connected to said first input terminal more conductive than the transistor (P1) connected to said first supply terminal (1).

3. The device of claim 1 or 2, wherein a second branch of two transistors (P1, N3) of opposite types in series connects said first terminal (1) of application of the second supply voltage (Vcc) to the second input terminal (43), the control terminals of the transistors of the second branch being connected to the junction points of the second capacitive (C2, C4) and resistive (R2, R4) elements, the junction point of the second branch defining a second output terminal (NOUT) providing a signal inverted with respect to the signal provided by the first output terminal.

4. The device of any of claims 1 to 3, wherein the capacitive elements (C1, C2, C3, C4) have values on the order of one femtofarad.

5. The device of any of claims 1 to 4, wherein the capacitive elements (C1, C2, C3, C4) all have the same values, the resistive elements (R1, R2, R3, R4) all having the same values.

6. The device of any of claims 1 to 4, wherein the capacitive elements (C3, C4) associated with the transistors of a first type (N3, N4) have a lower value than the capacitive elements (C1, C2) associated with the transistors of a second type (P1, P2), the corresponding resistive elements (R3, R4, R1, R2) following an inverse variation.

7. The device of any of claims 1 to 6, wherein said input terminals (43, 44) correspond to the respective outputs of inverters (41, 42) receiving as an input digital signals inverted with respect to each other, said inverters being powered by said first supply voltage (Vdd).

8. The device of claim 3 and any of claims 4 to 7, wherein said first terminal (1) of application of the second supply voltage (Vcc) is connected to each output terminal (NOUT, OUT) by an additional transistor of the first type (P7, P8), the control terminal of each additional transistor being connected by a controllable switch (K7, K8) to the other output terminal.

9. The device of any of claims 1 to 8, wherein the transistors of the first type are P-channel MOS transistors (P1, P2, P7, P8), the transistors of the second type being N-channel MOS transistors (N3, N4), the supply voltages (Vdd, Vcc) being positive with respect to a common reference level (2).

10. An input/output device receiving at least a first digital signal (Vin) of relatively low amplitude from a digital circuit (10) and providing at least one signal of relatively high amplitude intended for a second circuit (20), comprising at least one level shifter according to any of claims 1 to 9.

11. The device of claim 10, receiving a non-periodic signal.

12. The device of claim 10, wherein the converted signal is a differential clock signal.

## Patentansprüche

1. Ein Gerät zum Verschieben des Pegels eines ersten Signals (Vin) mit relativ kleiner Amplitude, die eine Funktion einer ersten Versorgungsspannung (Vdd) ist, zu einem zweiten Signal (Vout) mit relativ hoher Amplitude, die eine Funktion einer zweiten Versorgungsspannung (Vcc) ist, das Folgendes aufweist, zwischen einem ersten Anschluss (1) der Anwendung der zweiten Versorgungsspannung und einem ersten Eingabeanschluss (44), einen Bereich bzw. Zweig von zwei Transistoren (P2, N4) von entgegengesetzten Typen in Serie, wobei deren Verbindungspunkt einen Ausgabeanschluss (OUT) definiert, wobei die entsprechenden Steueranschlüsse der Transistoren mit den Anschlüssen (46, 45) der Anwendung von relativ hohen (HVbias) und niedrigen (LVbias) Biasspannungen durch erste resistive Elemente (R2, R4) verbunden sind, einen zweiten Eingabeanschluss (43), der das Inverse des Signals angewandt bei dem ersten Anschluss empfängt, verbunden zu jedem der Steueranschlüsse der Transistoren durch erste kapazitive Elemente (C2, C4) und der erste Eingabeanschluss verbunden zu jedem der Anschlüsse der Anwendung der Biasspannungen durch zweite kapazitive Elemente (C1, C3) in Serie mit den zweiten resistiven Elementen (R1, R3).

2. Gerät nach Anspruch 1, wobei die Biasspannungen (HVbias, LVbias) derart sind, dass die niedrige Spannung dem Transistor (N4), der mit dem ersten Eingabeanschluss verbunden ist, leitfähiger macht als der Transistor (P1), verbunden mit dem ersten Versorgungsanschluss (1).

3. Gerät nach Anspruch 1 oder 2, wobei ein zweiter Zweig von Transistoren (P1, N3) von entgegengesetzten Typen in Serie den ersten Anschluss (1) der Anwendung der zweiten Versorgungsspannung (Vcc) mit dem zweiten Eingabeanschluss (43) verbindet, wobei die Steueranschlüsse der Transistoren des zweiten Zweiges verbunden sind mit den Verknüpfungspunkten der zweiten kapazitiven (C2, C4) und resistiven (R2, R4) Elementen, wobei der Verknüpfungspunkt des zweiten Zweigs einen zweiten Ausgabeanschluss (NOUT) definiert, der ein Signal invertiert bezüglich des Signals, vorgesehen durch den ersten Ausgabeanschluss.

4. Gerät nach einem der Ansprüche 1 bis 3, wobei die kapazitiven Elemente (C1, C2, C3, C4) Werte haben von ungefähr einem Femtofarad.

5. Gerät nach einem der Ansprüche 1 bis 4, wobei die kapazitiven Elemente (C1, C2, C3, C4) alle die gleichen Werte haben, wobei die resistiven Elemente (R1, R2, R3, R4) alle die gleichen Werte haben.

6. Gerät nach einem der Ansprüche 1 bis 4, wobei die kapazitiven Elemente (C3, C4) assoziiert mit den Transistoren eines ersten Typs (N3, N4) einen niedrigeren Wert haben als die kapazitiven Elemente (C1, C2), assoziiert mit den Transistoren eines zweiten Typs (P1, P2), wobei die entsprechenden resistiven Elemente (R3, R4, R1, R2) einer inversen Variation folgen.

7. Gerät nach einem der Ansprüche 1 bis 6, wobei die Eingabeanschlüsse (43, 44) den entsprechenden Ausgängen der Inverter (41, 42) entsprechen, die als eine Eingabe digitale Signale invertiert bezüglich zueinander empfangen, wobei die Inverter von der ersten Versorgungsspannung (Vdd) versorgt werden.

8. Gerät nach Anspruch 3, und nach einem der Ansprüche 4 bis 7, wobei der erste Anschluss (1) der Anwendung der zweiten Versorgungsspannung (Vcc) verbunden ist zu jedem Ausgabeanschluss (NOUT, OUT) durch einen zusätzlichen Transistor des ersten Typs (P7, P8), wobei der Steueranschluss von jedem zusätzlichen Transistor verbunden ist durch einen steuerbaren Schalter (K7, K8) zu dem anderen Ausgabeanschluss.

9. Gerät nach einem der Ansprüche 1 bis 8, wobei die Transistoren des ersten Typs P-Kanal-MOS-Transistoren (P1, P2, P7, P8) sind, die Transistoren des zweiten Typs N-Kanal-MOS-Transistoren (N3, N4) sind, die Versorgungsspannungen (Vdd, Vcc) positiv bezüglich einem gemeinsamen Referenzpegel (2) sind.

10. Ein Eingabe-/Ausgabegerät, das wenigstens ein erstes digitales Signal (Vin) mit relativ niedriger Amplitude von einem digitalen Schaltkreis (10) empfängt, und wenigstens ein Signal mit relativ hoher Amplitude, das für einen zweiten Schaltkreis (20) gedacht ist, vorsieht, das wenigstens einen Pegelschieber gemäß einem der Ansprüche 1 bis 9 aufweist.

11. Gerät nach Anspruch 10, das ein nicht-periodisches Signal empfängt.

12. Gerät nach Anspruch 10, wobei das konvertierte Signal ein differenzielles Taktsignal ist.
